# EUROPEAN PATENT SPECIFICATION

(11) **EP 1 568 748 B1**
(45) Date of publication and mention of the grant of the patent: **17.12.2008**
(21) Application number: 05004055.9
(22) Date of filing: 24.02.2005
(51) Int. Cl.: C09J 133/00, C09J 7/02, C09J 133/18, C09J 161/06, B32B 7/12

(54) **Thermosetting adhesive or pressure-sensitive adhesive composition and thermosetting adhesive or pressure-sensitive adhesive tape or sheet**
Wärmehärtende Klebstoffzusammensetzung oder druckempfindliche Klebstoffzusammensetzung und wärmehärtenden Klebstoff oder druckempfindlichen Klebstoff enthaltende Bänder oder Folien
Composition adhésive thermodurcissable ou adhésive sensible à la pression, bande ou feuille adhésive thermodurcissable ou sensible à la pression

(30) Priority: 25.02.2004 JP 2004049900
(43) Date of publication of application: 31.08.2005
(73) Proprietor: NITTO DENKO CORPORATION, Osaka (JP)
(72) Inventor: Sonobe, Miyoko, Ibaraki-shi Osaka (JP); Ohura, Masahiro, Ibaraki-shi Osaka (JP)
(74) Representative: Grünecker, Kinkeldey, Stockmair & Schwanhäusser Anwaltssozietät

(56) References cited:
- US-A- 3 728 150
- US-A- 3 900 662
- PATENT ABSTRACTS OF JAPAN vol. 017, no. 361 (C-1080), 8 July 1993 (1993-07-08) & JP 05 051569 A (SEKISUI CHEM CO LTD; others: 01), 2 March 1993 (1993-03-02)

## Description

### FIELD OF THE INVENTION

The present invention relates to a thermosetting adhesive or pressure-sensitive adhesive composition and a thermosetting adhesive or pressure-sensitive adhesive tape or sheet. In more detail, the invention relates to a thermosetting adhesive or pressure-sensitive adhesive composition and a thermosetting adhesive or pressure-sensitive adhesive tape or sheet, each of which can be suitably used in flexible printing circuit boards and the like.

### BACKGROUND OF THE INVENTION

In electronic instruments, a flexible printing circuit board (sometimes referred to as "FPC") is widely utilized. In such an FPC, an adhesive is used during (1) a step of adhering and laminating a conductive metal foil (for example, copper foils and aluminum foils) on a heat-resistant substrate (for example, polyimide-made substrates and polyamide-made substrates) to prepare FPC or (2) a step of adhering FPC to a reinforcing plate (such as aluminum plates, stainless steel plates, and polyimide plates). As such an adhesive to be used in adhesion of FPC, there have hitherto been widely utilized nitrile rubber (NBR)/epoxy resin based adhesives and acrylic rubber/phenol resin based adhesives (see U.S. Patent Nos. 3,822,175 and 3,900,662).

However, since the conventional acrylic rubber/phenol resin based adhesives are non-sticky at the ambient temperature (23°C), it is impossible to perform a temporary lamination work at the ambient temperature in adhesion or pressure-sensitive adhesion of FPC during preparing FPC or during laminating FPC to a reinforcing plate, etc. For that reason, in processing lines or the like, a specific heating tool is required, and therefore, it is considered that a lowering of the work efficiency or danger against workers is brought. Also, even if the acrylic rubber/phenol resin based adhesives would be provided with stickiness at the ambient temperature, in order to impart stickiness, an elastic modulus is inevitably lowered, leading to a lowering of the adhesive strength or heat resistance. Accordingly, it is difficult to take a good balance between the stickiness and the adhesiveness.

### SUMMARY OF THE INVENTION

Thus, an object of the invention is to provide a thermosetting adhesive or pressure-sensitive adhesive composition which can reveal good stickiness before setting and after setting by heating, can reveal excellent adhesiveness and heat resistance and a thermosetting adhesive or pressure-sensitive adhesive tape or sheet having a thermosetting adhesive or pressure-sensitive adhesive layer comprising the subject thermosetting adhesive or pressure-sensitive adhesive composition.

Another object of the invention is to provide a thermosetting adhesive or pressure-sensitive adhesive composition which can reveal a performance as a thermosetting adhesive or pressure-sensitive adhesive with a good balance and a thermosetting adhesive or pressure-sensitive adhesive tape or sheet having a thermosetting adhesive or pressure-sensitive adhesive layer comprising the subject thermosetting adhesive or pressure-sensitive adhesive composition.

A still another object of the invention is to provide a thermosetting adhesive or pressure-sensitive adhesive tape or sheet which can be subjected to temporary lamination at the ambient temperature; after positioning by temporary lamination, can be adhered with excellent adhesiveness; and can be suitably used during adhesion or pressure-sensitive adhesion in flexible printing circuit boards.

In order to achieve the foregoing objects, the present inventors made extensive and intensive investigations. As a result, it has been found that by combining a specific acrylic polymer with a specific phenol resin, stickiness for positioning can be revealed at the ambient temperature before setting, and after setting by heating, excellent adhesiveness and heat resistance can be revealed. The invention has been accomplished based on these findings.

Specifically, the invention is to provide a thermosetting adhesive or pressure-sensitive adhesive composition comprising 100 parts by weight of an acrylic polymer (X) containing from 60 to 75 % by weight, based on the total amount of monomer components, of an alkyl (meth)acrylate (a) in which the alkyl moiety thereof has from 2 to 14 carbon atoms, from 20 to 35 % by weight, based on the total amount of monomer components, of a cyano group-containing monomer (b), and from 0.5 to 10 % by weight, based on the total amount of monomer components, of a carboxyl group-containing monomer (c) as monomer components; and from 1 to 20 parts by weight of a carbolic acid based resol type phenol resin (Y) represented by the following formula (1).

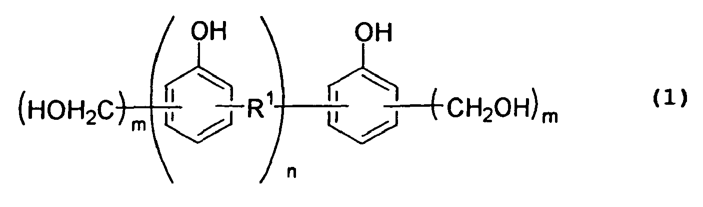

In the formula (1),R¹ represents -CH₂- or -CH₂-O-CH₂-; n represents a positive integer; and m represents an integer of from 1 to 4.

As the cyano group-containing monomer (b), acrylonitrile and/or methacrylonitrile can be suitably used; and as the carboxyl group-containing monomer (c), at least one carboxyl group-containing monomer selected from acrylic acid, methacrylic acid, and itaconic acid can be suitably used. The carbolic acid based resol type phenol resin (Y) is in the liquid state or balsam state at 50°C.

Also, the invention is to provide a thermosetting adhesive or pressure-sensitive adhesive tape or sheet having a thermosetting adhesive or pressure-sensitive adhesive layer formed of the foregoing thermosetting adhesive or pressure-sensitive adhesive composition. It is preferable that the thermosetting adhesive or pressure-sensitive adhesive layer has a storage elastic modulus (at 23°C) of from 1 × 10⁶ to 1 × 10⁸ Pa.

Since the thermosetting adhesive or pressure-sensitive adhesive composition of the invention has the foregoing construction, it can reveal good stickiness before setting; after setting by heating, can reveal excellent adhesiveness and heat resistance; and can reveal a performance as a thermosetting adhesive or pressure-sensitive adhesive with a good balance. Accordingly, the thermosetting adhesive or pressure-sensitive adhesive tape or sheet having a thermosetting adhesive or pressure-sensitive adhesive layer comprising the foregoing thermosetting adhesive or pressure-sensitive adhesive composition can be subjected to temporary lamination at the ambient temperature; after positioning by the temporary lamination, can be adhered with excellent adhesiveness; and can be suitably used during adhesion or pressure-sensitive adhesion in flexible printing circuit boards.

### DETAILED DESCRIPTION OF THE INVENTION

### [Acrylic polymer (X)]

The acrylic polymer (X) is an acrylic polymer containing from 60 to 75 % by weight, based on the total amount of monomer components, of an alkyl (meth)acrylate (a) in which the alkyl moiety thereof has from 2 to 14 carbon atoms [sometimes referred to as "C₂₋₁₄ alkyl (meth)acrylate"], from 20 to 35 % by weight, based on the total amount of monomer components, of a cyano group-containing monomer (b), and from 0.5 to 10 % by weight, based on the total amount of monomer components, of a carboxyl group-containing monomer (c) as monomer components.

### [C₂₋₁₄ Alkyl (meth)acrylate (a)]

The C₂₋₁₄ alkyl (meth)acrylate (a) is not particularly limited so far as it is an alkyl (meth)acrylate (an alkyl acrylate or an alkyl methacrylate) in which the alkyl moiety thereof has from 2 to 14 carbon atoms. Examples of the C₂₋₁₄ alkyl (meth)acrylate (a) include ethyl (meth)-acrylate, propyl (meth)acrylate, isopropyl (meth)acrylate, n-butyl (meth)acrylate, isobutyl (meth)acrylate, s-butyl (meth)acrylate, t-butyl (meth)acrylate, pentyl (meth)-acrylate, isopentyl (meth)acrylate, hexyl (meth)acrylate, heptyl (meth)acrylate, octyl (meth)acrylate, 2-ethylhexyl (meth)acrylate, isooctyl (meth)acrylate, nonyl (meth)-acrylate, isononyl (meth)acrylate, decyl (meth)acrylate, isodecyl (meth)acrylate, undecyl (meth)acrylate, dodecyl (meth)acrylate, tridecyl (meth)acrylate, and tetradecyl (meth) acrylate.

As the C₂₋₁₄ alkyl (meth) acrylate (a),alkyl (meth)acrylates in which the alkyl moiety thereof has from 4 to 12 carbon atoms are suitable. Of these, n-butyl acrylate can be especially suitably used.

The C₂₋₁₄ alkyl (meth)acrylate (a) may be constituted singly or in admixture of two or more kinds thereof. That is, as the C₂₋₁₄ alkyl (meth) acrylate (a), at least one alkyl (meth)acrylate selected among alkyl (meth)acrylates in which the alkyl moiety thereof has from 2 to 14 carbon atoms can be used.

In the invention, the C₂₋₁₄ alkyl (meth) acrylate (a) is used as the major component of monomers for constituting the acrylic polymer (X). The proportion of the C₂₋₁₄ alkyl (meth) acrylate (a) is from 60 to 75 % by weight based on the total amount of monomer components. The proportion of the C₂₋₁₄ alkyl (meth)acrylate (a) is preferably from 68 to 73 % by weight based on the total amount of monomer components.

### [Cyano group-containing monomer (b)]

The cyano group-containing monomer (b) is not particularly limited so far as it is a monomer containing a cyano group. Examples thereof include acrylonitrile and methacrylonitrile. As the cyano group-containing monomer (b), acrylonitrile can be suitably used.

The cyano group-containing monomer (b) may be constituted singly or in admixture of two or more kinds thereof.

In the invention, the cyano group-containing monomer (b) is used for the purpose of improving the heat resistance and adhesiveness. For that reason, it is important that the proportion of the cyano group-containing monomer (b) is from 20 to 35 % by weight based on the total amount of monomer components. When the proportion of the cyano group-containing monomer (b) is less than 20 % by weight based on the total amount of monomer components, the heat resistance becomes poor. On the other hand, when it exceeds 35 % by weight, the flexibility is inferior. The proportion of the cyano group-containing monomer (b) is preferably from 25 to 32 % by weight based on the total amount of monomer components.

### [Carboxyl group-containing monomer (c)]

The carboxyl group-containing monomer (c) is not particularly limited so far as it is a monomer containing a carboxyl group. Examples thereof include (meth)acrylic acid (acrylic acid or methacrylic acid), itaconic acid, maleic acid, fumaric acid, and crotonic acid. Also, acid anhydrides of these carboxyl group-containing monomers (for example, acid anhydride group-containing monomers such as maleic anhydride and itaconic anhydride) can be used as the carboxyl group-containing monomer (c). As the carboxyl group-containing monomer (c), acrylic acid, methacrylic acid, and itaconic acid can be suitably used.

The carboxyl group-containing monomer (c) may be constituted singly or in admixture of two or more kinds thereof.

In the invention, the carboxyl group-containing monomer (c) is used for the purpose of improving the adhesiveness. For that reason, it is important that the proportion of the carboxyl group-containing monomer (c) is from 0.5 to 10 % by weight based on the total amount of monomer components. When the proportion of the carboxyl group-containing monomer (c) is less than 0.5 % by weight based on the total amount of monomer components, an effect for improving the adhesiveness becomes poor. On the other hand, when it exceeds 10 % by weight, the flexibility is inferior. The proportion of the carboxyl group-containing monomer (c) is preferably from 1 to 2 % by weight based on the total amount of monomer components.

### [Other monomer components]

If desired, monomer components (copolymerizable monomers) which are copolymerizable with the C₂₋₁₄ alkyl (meth)acrylate (a), the cyano group-containing monomer (b), and the carboxyl group-containing monomer (c) may be used as a monomer component constituting the acrylic polymer (X). Examples of such copolymerizable monomers include methyl (meth) acrylate; C₁₅₋₂₀ alkyl (meth) acrylates such as pentadecyl (meth)acrylate, hexadecyl (meth)acrylate, heptadecyl (meth)acrylate, octadecyl (meth)acrylate, nonadecyl (meth) acrylate, and eicosyl (meth) acrylate; nonaromatic ring-containing (meth)acrylates such as cycloalkyl (meth)acrylates [for example, cyclohexyl (meth)acrylate] and isobornyl (meth)acrylate; aromatic ring-containing (meth)acrylates such as aryl (meth)acrylates [for example, phenyl (meth)acrylate], aryloxyalkyl (meth)acrylates [for example, phenoxyethyl (meth)acrylate], and arylalkyl (meth)acrylates [for example, benzyl (meth)acrylate]; epoxy group-containing acrylic monomers such as glycidyl (meth)acrylate and methylglycidyl (meth)acrylate; vinyl ester based monomers such as vinyl acetate and vinyl propionate; styrene based monomers such as styrene and α-methylstyrene; hydroxyl group-containing monomers such as hydroxyethyl (meth)-acrylate, hydroxypropyl (meth)acrylate, and hydroxybutyl (meth) acrylate; alkoxyalkyl (meth)acrylate based monomers such as methoxyethyl (meth)acrylate and ethoxyethyl (meth) acrylate; aminoalkyl (meth) acrylate based monomers such as aminoethyl (meth)acrylate, N,N-dimethylaminoethyl (meth)acrylate, and t-butylaminoethyl (meth)acrylate; (N-substituted) amide based monomers such as (meth)acrylamide, N,N-dimethyl (meth)acrylamide, N-butyl (meth) acrylamide, and N-hydroxy (meth)acrylamide; olefin based monomers such as ethylene, propylene, isoprene, and butadiene; and vinyl ether based monomers such as methyl vinyl ether.

Also, in the acrylic based polymer (X), polyfunctional monomers such as hexanediol di (meth) acrylate, (poly) ethylene glycol di (meth) acrylate, (poly)propylene glycol di(meth)acrylate, neopentyl glycol di(meth)acrylate, pentaerythritol di(meth)acrylate, glycerin di(meth)acrylate, trimethylolpropane tri(meth)acrylate, pentaerythritol tri(meth)acrylate, dipentaerythritol hexa(meth)acrylate, epoxy acrylate, polyester acrylate, urethane acrylate, divinylbenzene, butyl di(meth)acrylate, and hexyl di(meth)acrylate can be used as the copolymerizable monomer.

The acrylic based polymer (X) can be prepared by known or common polymerization processes (for example, a solution polymerization process, an emulsion polymerization process, a suspension polymerization process, a block polymerization process, and a polymerization process upon irradiation of UV rays).

A polymerization initiator, a chain transfer agent, and so on, which are used in the polymerization of the acrylic polymer (X), are not particularly limited but can be properly selected and used among those which are known or common. More specifically, examples of the polymerization initiator include azo based polymerization initiators such as 2,2'-azobisisobutyronitrile, 2,2'-azobis(4-methoxy-2,4-dimethylvaleronitrile), 2,2'-azobis(2,4-dimethylvaleronitrile), 2,2'-azobis(2-methylbutyronitrile), 1,1'-azobis(cyclohexane-1-carbonitrile), 2,2'-azobis(2,4,4-trimethylpentane), and dimethyl-2,2'-azobis(2-methylpropionate); and peroxide based polymerization initiators such as benzoyl peroxide, t-butyl hydroperoxide, di-t-butyl peroxide, t-butyl peroxybenzoate, dicumyl peroxide, 1,1-bis(t-butylperoxy)-3,3,5-trimethylcyclohexane, and 1,1-bis(t-butylperoxy)-cyclododecane. The polymerization initiator can be used singly or in combinations of two or more kinds thereof. The amount of the polymerization initiator to be used can be properly selected within the range which is usually used.

Also, examples of the chain transfer agent include 2-mercaptoethanol, lauryl mercaptan, glycidyl mercaptan, mercaptoacetic acid, 2-ethylhexyl thioglycolate, 2,3-di-mercapto-1-propanol, and α-methylstyrene dimer.

In the solution polymerization, various general solvents can be used. Examples of such solvents include organic solvents, for example, esters such as ethyl acetate and n-butyl acetate; aromatic hydrocarbons such as toluene and benzene; aliphatic hydrocarbons such as n-hexane and n-heptane; alicyclic hydrocarbons such as cyclohexane and methylcyclohexane; and ketones such as methyl ethyl ketone and methyl isobutyl ketone. The solvent can be used singly or in combinations of two or more kinds thereof.

The weight average molecular weight of the acrylic polymer (X) is not particularly limited but for example, can be properly selected within the range of from 100,000 to 1,000,000 (preferably from 200,000 to 800,000). The weight average molecular weight of the acrylic polymer (X) can be controlled by the kinds and use amounts of the polymerization initiator and the chain transfer agent, the temperature and time of the polymerization, and others such as the concentration of monomer and the dropping rate of monomer. The weight average molecular weight of the acrylic polymer (X) can be measured by, for example, gel permeation chromatography (GPC). In this case, the measurement conditions are not particularly limited but can be properly selected among known measurement conditions.

### [Carbolic acid based resol type phenol resin (Y)]

The carbolic acid based resol type phenol resin (Y) is a carbolic acid based resol type phenol resin represented by the following formula (1).

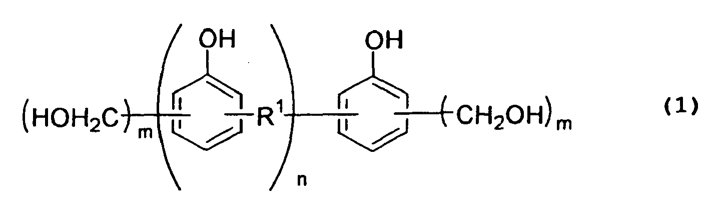

In the formula (1), R¹ represents -CH₂- or -CH₂-O-CH₂-; n represents a positive integer; and m represents an integer of from 1 to 4.

In the formula (1), n is not particularly limited so far as it is a positive integer but for example, can be selected among integers in the range of from 1 to 20. Also, m represents an integer of from 1 to 4.

The carbolic acid based resol type phenol resin (Y) is in the liquid state or balsam state at 50°C.

The carbolic acid based resol type phenol resin (Y) is used for the purpose of imparting thermosetting properties and heat resistance. The proportion of the carbolic acid based resol type phenol resin (Y) is from 1 to 20 parts by weight (preferably from 5 to 15 parts by weight) based on 100 parts by weight of the acrylic polymer (X). When the proportion of the carbolic acid based resol type phenol resin (Y) is less than 1 part by weight based on 100 parts by weight of the acrylic polymer (X), the thermosetting properties are insufficient. On the other hand, when it exceeds 20 parts by weight, the adhesive strength is lowered.

In the case where the carbolic acid based resol type phenol resin (Y) represented by the foregoing formula (1) is not used as the phenol resin, but an alkyl phenol resin represented by the following formula (2) is used, the adhesive characteristics become poor so that a thermosetting adhesive or pressure-sensitive adhesive composition having excellent adhesiveness is not obtained.

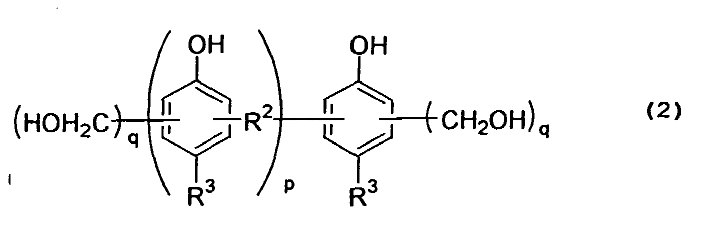

In the formula (2), R² represents -CH₂- or -CH₂-O-CH₂-; R³ represents an alkyl group; P represents a positive integer; and q represents an integer of from 1 to 3.

The alkyl group represented by R³ in the formula (2) is not particular limited, and examples thereof include alkyl groups such as a methyl group, an ethyl group, a propyl group, an isopropyl group, a butyl group, an isobutyl group, a s-butyl group, a t-butyl group, a pentyl group, a hexyl group, a heptyl group, and an octyl group. Also, p is not particularly limited so far as it is a positive integer but for example, can be selected among integers in the range of from 1 to 20. q represents an integer of from 1 to 3.

### [Thermosetting adhesive or pressure-sensitive adhesive composition]

The thermosetting adhesive or pressure-sensitive adhesive composition of the invention contains the foregoing acrylic polymer (X) and the foregoing carbolic acid based resol type phenol resin (Y). In the thermosetting adhesive or pressure-sensitive adhesive composition, with respect to the proportion of the acrylic polymer (X) and the carbolic acid based resol type phenol resin (Y), as described previously, the amount of the carbolic acid resol type phenol resin (Y) is from 1 to 20 parts by weight (preferably from 5 to 15 parts by weight) based on 100 parts by weight of the acrylic polymer (X).

In the thermosetting adhesive or pressure-sensitive adhesive composition, if desired, known additives such as an antiaging agent, a filler, a coloring agent (for example, pigments and dyes), an ultraviolet absorber, an antioxidant, a crosslinking agent, a tackifier, a plasticizer, a softener, a surfactant, and an antistatic agent may be contained within the range where the characteristics of the invention are not impaired, in addition to the acrylic polymer (X) and the carbolic acid based resol type phenol resin (Y).

The thermosetting adhesive or pressure-sensitive adhesive composition can be prepared by mixing the acrylic polymer (X), the carbolic acid based resol type phenol resin (Y), and optionally, various additives (for example, an antiaging agent, a filler, and a pigment), etc.

The acrylic polymer (X) and the carbolic acid based resol type phenol resin (Y) can be used in the solution or dispersion state. In the case where the acrylic polymer (X) is used in the solution state, a solvent is not particularly limited but for example, can be properly selected among the solvents enumerated as the solvent to be used for preparing the acrylic polymer (X) by solution polymerization. Also, in the case where the carbolic acid based resol type phenol resin (Y) is used in the solution state, a solvent is not particularly limited. For example, monohydric alcohols such as methanol, ethanol, propanol, isopropanol, and butanol; polyhydric alcohols such as ethylene glycol; ketones; acetic esters; and ethers can be used.

In the thermosetting adhesive or pressure-sensitive adhesive composition or the thermosetting adhesive or pressure-sensitive adhesive layer formed of the subject thermosetting adhesive or pressure-sensitive adhesive composition, it is desired that the storage elastic modulus at 23°C is from 1 × 10⁶ to 1 × 10⁸ Pa (preferably from 1 × 10⁷ to 8 × 10⁷ Pa, and more preferably from 1.2 × 10⁷ to 5 × 10⁷ Pa). When the storage elastic modulus at 23°C is less than 1 × 10⁶ Pa, though the stickiness is enhanced, the heat resistance is liable to be lowered. On the other hand, when it exceeds 1 × 10⁸ Pa, though the heat resistance is enhanced, the stickiness is liable to be lowered.

The storage elastic modulus of the thermosetting adhesive or pressure-sensitive adhesive composition or the thermosetting adhesive or pressure-sensitive adhesive layer formed of the subject thermosetting adhesive or pressure-sensitive adhesive composition can be measured under measurement conditions of a frequency of 1 Hz and a strain of 5 % using a rheometer [a unit trade name: ARES (manufactured by RHEOMETRICS).

### [Thermosetting adhesive or pressure-sensitive adhesive tape or sheet]

The thermosetting adhesive or pressure-sensitive adhesive tape or sheet of the invention is a thermosetting adhesive or pressure-sensitive adhesive tape or sheet having a thermosetting adhesive or pressure-sensitive adhesive layer formed of the foregoing thermosetting adhesive or pressure-sensitive adhesive composition. So far as the thermosetting adhesive or pressure-sensitive adhesive tape or sheet has a thermosetting adhesive or pressure-sensitive adhesive layer comprising the foregoing thermosetting adhesive or pressure-sensitive adhesive composition, it may have a substrate or may not have a substrate. Accordingly, examples of the thermosetting adhesive or pressure-sensitive adhesive tape or sheet include (1) a thermosetting adhesive or pressure-sensitive adhesive tape or sheet having a construction formed of only the thermosetting adhesive or pressure-sensitive adhesive layer (substrate-less thermosetting adhesive or pressure-sensitive adhesive tape or sheet) and (2) a thermosetting adhesive or pressure-sensitive adhesive tape or sheet having a construction in which the thermosetting adhesive or pressure-sensitive adhesive layer is formed on at least one surface (both surfaces or one surface) of a substrate (substrate-provided thermosetting adhesive or pressure-sensitive adhesive tape or sheet). As the thermosetting adhesive or pressure-sensitive adhesive tape or sheet, a thermosetting adhesive or pressure-sensitive adhesive tape or sheet having the foregoing construction (1) (that is, a substrate-less thermosetting adhesive or pressure-sensitive adhesive tape or sheet having a construction formed of only the thermosetting adhesive or pressure-sensitive adhesive layer) is suitable.

In the case where the thermosetting adhesive or pressure-sensitive adhesive tape or sheet is a substrate-provided thermosetting adhesive or pressure-sensitive adhesive tape or sheet, so far as a thermosetting adhesive or pressure-sensitive adhesive layer comprising the foregoing thermosetting adhesive or pressure-sensitive adhesive composition is formed on at least one surface of a substrate, a thermosetting adhesive or pressure-sensitive adhesive layer other than the foregoing thermosetting adhesive or pressure-sensitive adhesive layer may be formed on the other surface of the substrate, in addition to known pressure-sensitive adhesive layers and adhesive layers.

Also, the thermosetting adhesive or pressure-sensitive adhesive tape or sheet may be formed in the wound state in the roll form, or the sheet may be formed in the laminated state. That is, the thermosetting adhesive or pressure-sensitive adhesive tape or sheet of the invention can have the state in the sheet form, tape form, etc. In the case where the thermosetting adhesive or pressure-sensitive adhesive tape or sheet has the wound state in the roll form, for example, the thermosetting adhesive or pressure-sensitive adhesive layer may have the wound state in the roll form where it is protected by a release treatment layer formed on a separator or in the back face side of a substrate.

### (Thermosetting adhesive or pressure-sensitive adhesive layer)

As described previously, the thermosetting adhesive or pressure-sensitive adhesive layer is formed of the foregoing thermosetting adhesive or pressure-sensitive adhesive composition. Accordingly, the thermosetting adhesive or pressure-sensitive adhesive layer is a thermosetting adhesive or pressure-sensitive adhesive layer having stickiness such that it can be stuck to an adherend at the ambient temperature and adhesiveness such that it causes setting reaction by heating and increases an adhesive strength, whereby it can be firmly adhered to an adherend with excellent heat resistance.

The thickness of the thermosetting adhesive or pressure-sensitive adhesive layer can be, for example, selected within the range of from 5 to 100 µm (preferably from 10 to 50 µm, and more preferably from 20 to 30 µm). The thermosetting adhesive or pressure-sensitive adhesive layer may have any state of a single layer or a laminate.

As described previously, in the invention, it is desired that the thermosetting adhesive or pressure-sensitive adhesive layer has a storage elastic modulus at 23°C of from 1 × 10⁶ to 1 × 10⁸ Pa (preferably from 1 × 10⁷ to 8 × 10⁷ Pa, and more preferably from 1.2 × 10⁷ to 5 × 10⁷ Pa).

The thermosetting adhesive or pressure-sensitive adhesive layer may be protected by a release liner. Such a release liner is not particularly limited but can be properly selected and used among known release liners.

In the case where the thermosetting adhesive or pressure-sensitive adhesive tape or sheet has a substrate, the substrate is not particularly limited. Examples thereof include appropriate thin sheet materials including paper based substrates such as papers; fiber based substrates such as cloths, non-woven fabrics, and nets; metal based substrates such as metal foils and metal plates; plastic based substrates such as films or sheets made of various resins (for example, olefin based resins, polyester based resins, polyvinyl chloride based resins, vinyl acetate based resins, amide based resins, polyimide based resins, polyetheretherketone (PEEK), and polyphenylene sulfide (PPS)); rubber based substrates (for example, rubber sheets); foamed articles (for example, foamed sheets); and laminates thereof (especially, laminates of a plastic based substrate and other substrate, and laminates of plastic films (or sheets) each other).

The thickness of the substrate is not particularly limited but for example, may be from approximately 10 to 500 µm (preferably from 12 to 200 µm, and more preferably from 15 to 100 µm). The substrate may have the single-layered state or multilayered state. Also, if desired, the substrate may be subjected to various treatments such as a back face treatment, an antistatic treatment, and an undercoating treatment.

The thermosetting adhesive or pressure-sensitive adhesive tape or sheet may have other layers (for example, an interlayer and an undercoat layer) within the range where the effects of the invention are not impaired.

The thermosetting adhesive or pressure-sensitive adhesive tape or sheet of the invention can be produced according to usual production processes of pressure-sensitive adhesive tapes or sheets. For example, in the case where the thermosetting adhesive or pressure-sensitive adhesive tape or sheet is a substrate-less thermosetting adhesive or pressure-sensitive adhesive tape or sheet, it can be prepared by a process in which the foregoing thermosetting adhesive or pressure-sensitive adhesive composition is coated on the release surface of a release liner in such a manner that the thickness after drying becomes a prescribed thickness and then dried.

In coating the thermosetting adhesive or pressure-sensitive adhesive composition, common coaters (for example, a gravure roll coater, a reverse roll coater, a kiss roll coater, a dip roll coater, a bar coater, a knife coater, and a spray coater) can be used.

In laminating the thermosetting adhesive or pressure-sensitive adhesive tape or sheet of the invention to an adherend by temporary lamination before setting by heating, it can be stuck to the adherend by temporary lamination while utilizing its stickiness. Also, after lamination by sticking, the thermosetting adhesive or pressure-sensitive adhesive tape or sheet is set by heating, whereby it can be firmly adhered to the adherend. It this way, the thermosetting adhesive or pressure-sensitive adhesive tape or sheet can not only reveal a performance as a thermosetting adhesive or pressure-sensitive adhesive with a good balance but also reveal excellent heat resistance (especially, heat resistance after wet heat) after thermosetting. Accordingly, the thermosetting adhesive or pressure-sensitive adhesive tape or sheet can be subjected to temporary lamination at the ambient temperature and at this time, can be easily subjected to re-lamination. Thus, its lamination work is very simple so that the thermosetting adhesive or pressure-sensitive adhesive tape or sheet is excellent in the lamination workability. Also, when positioning is performed by temporary lamination and after lamination by sticking, setting reaction is caused by heating, it is possible to adhere a laminate resulting from sticking with excellent adhesiveness. For that reason, the thermosetting adhesive or pressure-sensitive adhesive tape or sheet of the invention can be suitably used for applications required such that it can be subjected to temporary lamination by sticking at the ambient temperature and after the temporary lamination, can be firmly adhered with excellent heat resistance by heating. Specifically, the thermosetting adhesive or pressure-sensitive adhesive tape or sheet can be suitably used in adhesion or pressure-sensitive adhesion in flexible printing circuit boards (FPC). The term "adhesion or pressure-sensitive adhesion of FPC" as referred to herein means adhesion or pressure-sensitive adhesion during preparing FPC or adhesion or pressure-sensitive adhesion during laminating FPC on a reinforcing plate as described previously.

The invention will be described below in detail with reference to the Examples, but it should not be construed that the invention is limited to these Examples.

### EXAMPLE 1

An ethyl acetate solution having dissolved therein 100 parts by weight of an acrylic polymer [a copolymer of butyl acrylate (BA)/acrylonitrile (AN)/acrylic acid (AA) = 69/30/1 (by weight)] was mixed with a methanol solution having dissolved therein 10 parts by weight of a trade name: SUMILITE RESIN PR-51283 (manufactured by SUMITOMO BAKELITE CO., LTD.) as a carbolic acid based resol type phenol resin, which is liquid at 50°C, and the mixture was stirred, thereby preparing a thermosetting adhesive or pressure-sensitive adhesive composition solution. That is, this thermosetting adhesive or pressure-sensitive adhesive composition solution contains 100 parts by weight of the acrylic polymer and 10 parts by weight of the carbolic acid based resol type phenol resin.

The thermosetting adhesive or pressure-sensitive adhesive composition solution was coated on the release surface of a release liner in a thickness after drying of 25 µm and dried at 100°C for 3 minutes, thereby obtaining a thermosetting adhesive or pressure-sensitive adhesive sheet.

### EXAMPLE 2

An ethyl acetate solution having dissolved therein 100 parts by weight of an acrylic polymer [a copolymer of butyl acrylate (BA)/acrylonitrile (AN)/acrylic acid (AA) = 69/30/1 (by weight)] was mixed with a methanol solution having dissolved therein 10 parts by weight of a trade name: TAMANOL AS (manufactured by ARAKAWA CHEMICAL INDUSTRIES, LTD.) as a carbolic acid based resol type phenol resin, which is liquid at 50°C, and the mixture was stirred, thereby preparing a thermosetting adhesive or pressure-sensitive adhesive composition solution. That is, this thermosetting adhesive or pressure-sensitive adhesive composition solution contains 100 parts by weight of the acrylic polymer and 10 parts by weight of the carbolic acid based resol type phenol resin.

The thermosetting adhesive or pressure-sensitive adhesive composition solution was coated on the release surface of a release liner in a thickness after drying of 25 µm and dried at 100°C for 3 minutes, thereby obtaining a thermosetting adhesive or pressure-sensitive adhesive sheet.

### EXAMPLE 3

An ethyl acetate solution having dissolved therein 100 parts by weight of an acrylic polymer [a copolymer of butyl acrylate (BA)/acrylonitrile (AN)/acrylic acid (AA) = 74/25/1 (by weight)] was mixed with a methanol solution having dissolved therein 10 parts by weight of a trade name: SUMILITE RESIN PR-51283 (manufactured by SUMITOMO BAKELITE CO., LTD.) as a carbolic acid based resol type phenol resin, which is liquid at 50°C, and the mixture was stirred, thereby preparing a thermosetting adhesive or pressure-sensitive adhesive composition solution. That is, this thermosetting adhesive or pressure-sensitive adhesive composition solution contains 100 parts by weight of the acrylic polymer and 10 parts by weight of the carbolic acid based resol type phenol resin.

The thermosetting adhesive or pressure-sensitive adhesive composition solution was coated on the release surface of a release liner in a thickness after drying of 25 µm and dried at 100°C for 3 minutes, thereby obtaining a thermosetting adhesive or pressure-sensitive adhesive sheet.

### EXAMPLE 4

An ethyl acetate solution having dissolved therein 100 parts by weight of an acrylic polymer [a copolymer of butyl acrylate (BA)/acrylonitrile (AN)/acrylic acid (AA) = 74/25/1 (by weight)] was mixed with a methanol solution having dissolved therein 10 parts by weight of a trade name: TAMANOL AS (manufactured by ARAKAWA CHEMICAL INDUSTRIES, LTD.) as a carbolic acid based resol type phenol resin, which is liquid at 50°C, and the mixture was stirred, thereby preparing a thermosetting adhesive or pressure-sensitive adhesive composition solution. That is, this thermosetting adhesive or pressure-sensitive adhesive composition solution contains 100 parts by weight of the acrylic polymer and 10 parts by weight of the carbolic acid based resol type phenol resin.

The thermosetting adhesive or pressure-sensitive adhesive composition solution was coated on the release surface of a release liner in a thickness after drying of 25 µm and dried at 100°C for 3 minutes, thereby obtaining a thermosetting adhesive or pressure-sensitive adhesive sheet.

### COMPARATIVE EXAMPLE 1

An ethyl acetate solution having dissolved therein 100 parts by weight of an acrylic polymer [a copolymer of butyl acrylate (BA)/acrylonitrile (AN)/acrylic acid (AA) = 58/40/2 (by weight)] was mixed with a methanol solution having dissolved therein 10 parts by weight of a trade name: SUMILITE RESIN PR-51283 (manufactured by SUMITOMO BAKELITE CO., LTD.) as a carbolic acid based resol type phenol resin, which is liquid at 50°C, and the mixture was stirred, thereby preparing a thermosetting adhesive or pressure-sensitive adhesive composition solution. That is, this thermosetting adhesive or pressure-sensitive adhesive composition solution contains 100 parts by weight of the acrylic polymer and 10 parts by weight of the carbolic acid based resol type phenol resin.

The thermosetting adhesive or pressure-sensitive adhesive composition solution was coated on the release surface of a release liner in a thickness after drying of 25 µm and dried at 100°C for 3 minutes, thereby obtaining a thermosetting adhesive or pressure-sensitive adhesive sheet.

### COMPARATIVE EXAMPLE 2

An ethyl acetate solution having dissolved therein 100 parts by weight of an acrylic polymer [a copolymer of butyl acrylate (BA)/acrylonitrile (AN)/acrylic acid (AA) = 83/15/2 (by weight)] was mixed with a methanol solution having dissolved therein 10 parts by weight of a trade name: TAMANOL AS (manufactured by ARAFCAWA CHEMICAL INDUSTRIES, LTD.) as a carbolic acid based resol type phenol resin, which is liquid at 50°C, and the mixture was stirred, thereby preparing a thermosetting adhesive or pressure-sensitive adhesive composition solution. That is, this thermosetting adhesive or pressure-sensitive adhesive composition solution contains 100 parts by weight of the acrylic polymer and 10 parts by weight of the carbolic acid based resol type phenol resin.

The thermosetting adhesive or pressure-sensitive adhesive composition solution was coated on the release surface of a release liner in a thickness after drying of 25 µm and dried at 100°C for 3 minutes, thereby obtaining a thermosetting adhesive or pressure-sensitive adhesive sheet.

### COMPARATIVE EXAMPLE 3

An ethyl acetate solution having dissolved therein 100 parts by weight of an acrylic polymer [a copolymer of butyl acrylate (BA)/acrylonitrile (AN)/acrylic acid (AA) = 83/16/1 (by weight)] was mixed with a methanol solution having dissolved therein 15 parts by weight of a trade name: SUMILITE RESIN PR-175 (manufactured by SUMITOMO BAKELITE CO., LTD.) as a carbolic acid based resol type phenol resin, which is a solid at 50°C, and the mixture was stirred, thereby preparing a thermosetting adhesive or pressure-sensitive adhesive composition solution. That is, this thermosetting adhesive or pressure-sensitive adhesive composition solution contains 100 parts by weight of the acrylic polymer and 15 parts by weight of the carbolic acid based resol type phenol resin.

The thermosetting adhesive or pressure-sensitive adhesive composition solution was coated on the release surface of a release liner in a thickness after drying of 25 µm and dried at 100°C for 3 minutes, thereby obtaining a thermosetting adhesive or pressure-sensitive adhesive sheet.

### COMPARATIVE EXAMPLE 4

An ethyl acetate solution having dissolved therein 100 parts by weight of an acrylic polymer [a copolymer of butyl acrylate (BA)/acrylonitrile (AN)/acrylic acid (AA) = 69/30/1 (by weight)] was mixed with a methanol solution having dissolved therein 10 parts by weight of a trade name: HITANOL 643KN (manufactured by HITACHI CHEMICAL CO., LTD.) as a solid alkyl phenol resin, and the mixture was stirred, thereby preparing a thermosetting adhesive or pressure-sensitive adhesive composition solution. That is, this thermosetting adhesive or pressure-sensitive adhesive composition solution contains 100 parts by weight of the acrylic polymer and 10 parts by weight of the alkyl phenol resin.

The thermosetting adhesive or pressure-sensitive adhesive composition solution was coated on the release surface of a release liner in a thickness after drying of 25 µm and dried at 100°C for 3 minutes, thereby obtaining a thermosetting adhesive or pressure-sensitive adhesive sheet.

### (Evaluation)

With respect to each of the thermosetting adhesive or pressure-sensitive adhesive sheets obtained in the Examples and Comparative Examples, the thermosetting adhesive or pressure-sensitive adhesive layer was measured or evaluated for storage elastic modulus, sticking strength at the ambient temperature before setting, adhesive strength after setting and heat resistance in the following measurement method of storage elastic modulus, measurement method of sticking strength, measurement method of adhesive strength and measurement method of heat resistance, respectively.

### (Measurement method of storage elastic modulus)

With respect to the thermosetting adhesive or pressure-sensitive adhesive layer before setting in each of the thermosetting adhesive or pressure-sensitive adhesive sheets prepared in the Examples and Comparative Examples, the storage elastic modulus E' (Pa) at the ambient temperature (23°C) as an index of temporary lamination properties at the ambient temperature was measured under conditions of a frequency of 1 Hz and a strain of 5 % using a unit trade name "ARES" (manufactured by RHEOMETRICS). The measurement or evaluation results are shown in the "Storage elastic modulus E' (Pa)" row of Table 1 or 2.

### (Measurement method of sticking strength)

With respect to the thermosetting adhesive or pressure-sensitive adhesive layer before setting in each of the thermosetting adhesive or pressure-sensitive adhesive sheets prepared in the Examples and Comparative Examples, the sticking strength (N/20 mm) at the ambient temperature (23°C) as an index of temporary lamination properties at the ambient temperature was measured according to JIS Z0237. Specifically, a sample prepared by backing the thermosetting adhesive or pressure-sensitive adhesive sheet with a polyester based pressure-sensitive adhesive tape (a trade name: No. 31B, manufactured by NITTO DENKO CORPORATION) and cutting into a width of 20 mm was contact adhered to a polyimide film (a trade name: KAPTON 500V, manufactured by DuPont) through one reciprocation by a 2-kg roll, and its 180°-peel sticking strength (N/20 mm) (by drawing the sample at a peel rate of 100 mm/min and at 23°C) was measured using a unit trade name "TCM-1KNB" (manufactured by MINEBEA CO., LTD.). The measurement or evaluation results are shown in the "Sticking strength (N/20 mm)" row of Table 1 or 2.

### (Measurement method of adhesive strength)

With respect to the thermosetting adhesive or pressure-sensitive adhesive layer after setting in each of the thermosetting adhesive or pressure-sensitive adhesive sheets prepared in the Examples and Comparative Examples, the adhesive strength (N/cm) at 23°C after setting was measured. Specifically, after laminating a flexible printing circuit board (FPC, area: 5 cm × 8 cm, thickness: 0.2 mm) and the thermosetting adhesive or pressure-sensitive adhesive sheet at 130°C, the laminate was cut into a width of 1 cm, stuck onto an aluminum plate (area: 5 cm × 5 cm, thickness: 0.5 mm), further laminated at 130°C, heated for contact adhering at 160°C and at 1 MPa for 90 minutes, and further cured at 150°C for 3 hours, thereby preparing a specimen. With respect to this specimen, its 90° peel adhesive strength (N/cm) (by drawing the specimen at a peel rate of 50 mm/min and at 23°C) was measured by a method of drawing from the FPC side using a unit trade name "TCM-1KNB" (manufactured by MINEBEA CO., LTD.). The measurement or evaluation results are shown in the "Adhesive strength (N/cm)" row of Table 1 or 2.

### (Evaluation method of heat resistance)

A specimen was prepared in the same manner as in the foregoing measurement method of adhesive strength. When this specimen was allowed to stand under the humidification conditions (temperature: 60°C, humidity: 90 % RH) for 24 hours and then heated by a temperature profile under the conditions of a peak temperature of 270°C and a time of 15 seconds in a heating furnace by infrared rays (IR heating furnace), the thermosetting adhesive or pressure-sensitive adhesive layer in the thermosetting adhesive or pressure-sensitive adhesive sheet was visually confirmed with respect to the lifting and peeling state or foaming state. With respect to the heat resistance, the specimen in which neither lifting and peeling nor foaming was confirmed in the thermosetting adhesive or pressure-sensitive adhesive layer was evaluated as "A", and the specimen in which lifting and peeling or foaming was confirmed in the thermosetting adhesive or pressure-sensitive adhesive layer was evaluated as "B". The measurement or evaluation results are shown in the "Heat resistance" row of Table 1 or 2.

**Table 1**

| | | Example | | | |
|---|---|---|---|---|---|
| | | 1 | 2 | 3 | 4 |
| Composition ratio of acrylic polymer | | | | | |
| | BA | 69 | 69 | 74 | 74 |
| | AN | 30 | 30 | 25 | 25 |
| | AA | 1 | 1 | 1 | 1 |
| Phenol resin | | | | | |
| | Kind | Carbolic acid based resol type phenol resin | Carbolic acid based resol type phenol resin | Carbolic acid based resol type phenol resin | Carbolic acid based resol type phenol resin |
| | Proportion ^{*1} | 10 | 10 | 10 | 10 |
| Storage elastic modulus E' (Pa) | | 1.67 × 10⁷ | 1.67 × 10⁷ | 1.58 × 10⁷ | 1.58 × 10⁷ |
| Sticking strength (N/20 mm) | | 3 | 3 | 4 | |
| Adhesive strength (N/cm) | | 23 | 22 | 20 | 20 |
| Heat resistance | | A | A | A | A |

| | | | | | |
|---|---|---|---|---|---|
| *1: Blending amount (parts by weight) based on 100 parts by weight of the acrylic polymer | | | | | |

**Table 2**

| | | Comparative Example | | | |
|---|---|---|---|---|---|
| | | 1 | 2 | 3 | 4 |
| Composition ratio of acrylic polymer | | | | | |
| | BA | 58 | 83 | 83 | 69 |
| | AN | 40 | 15 | 16 | 30 |
| | AA | 2 | 2 | 1 | 1 |
| Phenol resin | | | | | |
| | Kind | Carbolic acid based resol type phenol resin | Carbolic acid based resol type phenol resin | Carbolic acid based resol type phenol resin | Alkyl phenol resin |
| | Proportion ^{*1} | 10 | 10 | 15 | 10 |
| Storage elastic modulus E' (Pa) | | 4.36 × 10⁸ | 1.12 × 10⁶ | 1.10 × 10⁶ | 1.67 × 10⁷ |
| Sticking strength (N/20 mm) | | 0.6 | 6 | 2 | 3 |
| Adhesive strength (N/cm) | | 10 | 8 | 12 | 4 |
| Heat resistance | | A | B | B | B |

| | | | | | |
|---|---|---|---|---|---|
| *1: Blending amount (parts by weight) based on 100 parts by weight of the acrylic polymer | | | | | |

As is evident from Tables 1 to 2, the thermosetting adhesive or pressure-sensitive adhesive sheets according to the Examples have stickiness (stickiness for positioning) such that they can be laminated on an adherend with good stickiness at the ambient temperature and can be adhered with excellent adhesiveness by heating after the lamination. Moreover, after standing under a high humidity, their heat resistance after heating at a high temperature (heat resistance after wet heat) is good. Accordingly, the thermosetting adhesive or pressure-sensitive adhesive sheets according to the Examples are excellent in the workability during adhesion and excellent in the adhesiveness.

## Claims

1. A thermosetting adhesive or pressure-sensitive adhesive composition comprising 100 parts by weight of an acrylic polymer (X) containing from 60 to 75% by weight, based on the total amount of monomer components, of an alkyl (meth)acrylate (a) in which the alkyl moiety thereof has from 2 to 14 carbon atoms, from 20 to 35% by weight, based on the total amount of monomer components, of a cyano group-containing monomer (b), and from 0.5 to 10% by weight, based on the total amount of monomer components, of a carboxyl group-containing monomer (c) as monomer components; and from 1 to 20 parts by weight of a carbolic acid based resol type phenol resin (Y) represented by the following formula (1): 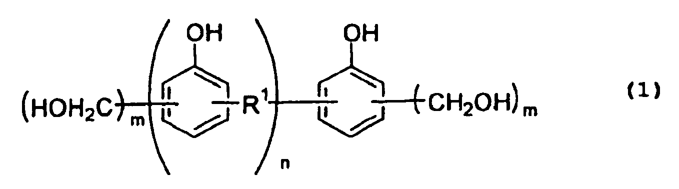 wherein R¹ represents -CH₂- or -CH₂-O-CH₂-; n represents a positive integer; and m represents an integer of from 1 to 4
wherein the carbolic acid based resol type phenol resin (Y) is in the liquid state or balsam state at 50°C.

2. The thermosetting adhesive or pressure-sensitive adhesive composition according to claim 1, wherein the cyano group-containing monomer (b) is acrylonitrile and/or methacrylonitrile.

3. The thermosetting adhesive or pressure-sensitive adhesive composition according to claim 1 or 2, wherein the carboxyl group-containing monomer (c) is at least one carboxyl group-containing monomer selected from acrylic acid, methacrylic acid, and itaconic acid.

4. A thermosetting adhesive or pressure-sensitive adhesive tape or sheet having a thermosetting adhesive or pressure-sensitive adhesive layer formed of the thermosetting adhesive or pressure-sensitive adhesive composition according to any one of claims 1 to 3.

5. The thermosetting adhesive or pressure-sensitive adhesive tape or sheet according to claim 4, wherein the thermosetting adhesive or pressure-sensitive adhesive layer has a storage elastic modulus (at 23°C) of form 1 x 10⁶ to 1 x 10⁸ Pa.

## Patentansprüche

1. Wärmehärtende Klebstoffzusammensetzung oder druckempfindliche Klebstoffzusammensetzung, umfassend 100 Gewichtsteile eines Acrylpolymers (X), enthaltend 60 bis 75 Gew.-%, bezogen auf die Gesamtmenge von Monomerkomponenten, eines Alkyl(meth)acrylats (a), in welchem seine Alkylkomponente 2 bis 14 Kohlenstoffatome hat, 20 bis 35 Gew.-%, bezogen auf die Gesamtmenge von Monomerkomponenten, eines Cyangruppe enthaltenden Monomers (b) und 0,5 bis 10 Gew.-%, bezogen auf die Gesamtmenge von Monomerkomponenten, eines Carboxylgruppe enthaltenden Monomers (c) als Monomerkomponenten, und 1 bis 20 Gew.-% eines Phenolharzes vom Resoltyp auf Basis von Carbolsäure (Y), wiedergegeben durch die folgende Formel (1); 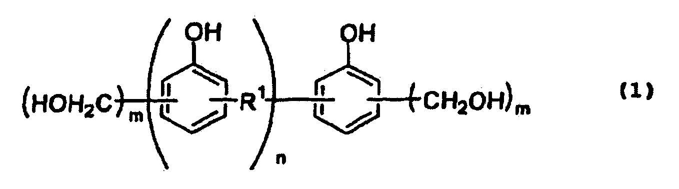 worin R¹ -CH₂- oder -CH₂-O-CH₂- bedeutet, n eine ganze Zahl bedeutet und m eine ganze Zahl von 1 bis 4 bedeutet, worin das Phenolharz vom Resoltyp auf Basis von Carbolsäure (Y) sich bei 50°C im flüssigen Zustand oder im Balsamzustand befindet.

2. Wärmehärtende Klebstoffzusammensetzung oder druckempfindliche Klebstoffzusammensetzung gemäß Anspruch 1, worin das Cyanogruppe enthaltende Monomer (b) Acrylnitril und/oder Methacrylnitril ist.

3. Wärmehärtende Klebstoffzusammensetzung oder druckempfindliche Klebstoffzusammensetzung gemäß Anspruch 1 oder 2, worin das Carboxylgruppe enthaltende Monomer (c) wenigstens ein Carboxylgruppe enthaltendes Monomer ist, ausgewählt aus Acrylsäure, Methacrylsäure und Itaconsäure.

4. Wärmehärtendes Klebstoffband oder wärmehärtende Klebstofffolie oder druckempfindliches Klebstoffband oder druckempfindliche Klebstofffolie mit einer wärmehärtenden oder druckempfindlichen Klebstoffschicht, gebildet aus der wärmehärtenden Klebstoffzusammensetzung oder druckempfindlichen Klebstoffzusammensetzung gemäß einem der Ansprüche 1 bis 3.

5. Wärmehärtendes Klebstoffband oder wärmehärtende Klebstofffolie oder druckempfindliches Klebstoffband oder druckempfindliche Klebstofffolie gemäß Anspruch 4, worin die wärmehärtende Klebstoffschicht oder druckempfindliche Klebstoffschicht einen Lagerelastizitätsmodul (bei 23°C) von 1 x 10⁸ bis 1 x 10⁸ Pa hat.

## Revendications

1. Composition adhésive thermodurcissable ou adhésive autocollante, comprenant 100 parties en poids d'un polymère acrylique (X) contenant de 60 à 75% en poids, sur base de la quantité totale de composants monomères, d'un (méth)acrylate d'alkyle (a), dans lequel la partie alkyle a 2 à 14 atomes de carbone, 20 à 35% en poids, sur base de la quantité totale de composants monomères, d'un monomère (b) contenant un groupe cyano, et 0,5 à 10% en poids, sur base de la quantité totale de composants monomères, d'un monomère (c) contenant un groupe carboxyle, comme composants monomères ; et 1 à 20 parties en poids d'une résine phénolique (Y) de type résol à base d'acide carbolique, représentée par la formule (1) : 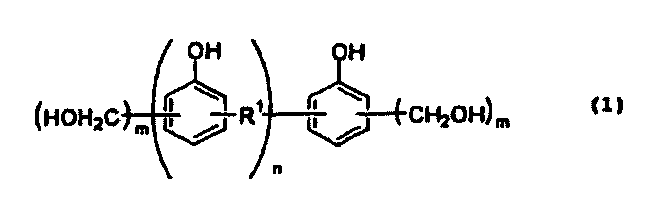 où R¹ représente -CH₂- ou -CH₂-O-CH₂-, n représente un entier positif et m représente un entier allant de 1 à 4,
où la résine phénolique (Y) de type résol à base d'acide carbolique est à l'état liquide ou à l'état de baume à 50°C.

2. Composition adhésive thermodurcissable ou adhésive autocollante selon la revendication 1, où le monomère (b) contenant un groupe cyano est l'acrylonitrile et/ou le méthacrylonitrile.

3. Composition adhésive thermodurcissable ou adhésive autocollante selon la revendication 1 ou 2, où le monomère (c) contenant un groupe carboxyle est au moins un monomère contenant un groupe carboxyle choisi parmi l'acide acrylique, l'acide méthacrylique et l'acide itaconique.

4. Bande ou feuille adhésive thermodurcissable ou adhésive autocollante, ayant une couche adhésive thermodurcissable ou adhésive autocollante formée de la composition adhésive thermodurcissable ou adhésive autocollante selon l'une quelconque des revendications 1 à 3.

5. Bande ou feuille adhésive thermodurcissable ou adhésive autocollante selon la revendication 4, où la couche adhésive thermodurcissable ou adhésive autocollante présente un module élastique au stockage (à 23°C) allant de 1 x 10⁶ à 1 x 10⁸ Pa.
